# EUROPEAN PATENT APPLICATION

(11) **EP 4 365 958 A1**
(43) Date of publication of application: **08.05.2024**
(21) Application number: 22217146.4
(22) Date of filing: 29.12.2022
(51) Int. Cl.: H01L 31/0224, H01L 31/0352

(54) **SOLAR CELL, METHOD FOR PRODUCING THE SAME AND PHOTOVOLTAIC MODULE**

(30) Priority: 03.11.2022 CN 202211369894
(71) Applicant: Zhejiang Jinko Solar Co., Ltd., Haining, Zhejiang (CN); JINKO SOLAR CO., LTD, ShangRao, Jiangxi 334100 (CN)
(72) Inventor: LI, Wenqi, Haining (CN); XIE, Minghui, Haining (CN); CHEN, Yifan, Haining (CN); ZHANG, Guochun, Haining (CN); ZHENG, Peiting, Haining (CN); YANG, Jie, Haining (CN); ZHANG, Xinyu, Haining (CN)
(74) Representative: Murgitroyd & Company

(57) **Abstract**

Embodiments of the present disclosure relates to a solar cell, a method for producing the solar cell and a photovoltaic module. The solar cell includes a substrate having a surface with a plurality of recess sets arranged at intervals along a first direction, each recess set of the plurality of recess sets including a plurality of recesses arranged at intervals along a second direction, and a distance d between adjacent recesses of the each recess set is greater than zero and less than 4L, L being a maximum dimension of a single recess of the plurality of recesses in the second direction; and a plurality of grid lines formed over the surface of the substrate. Each of the plurality of grid lines is formed in a region defined by a respective recess set and includes a first plating layer. The first plating layer includes portions formed on the surface of the substrate and extension portions extending into respective recesses of a respective recess set. Each of the extension portions is formed in a respective recess of the respective recess set and is in contact with the substrate through the recess. Embodiments of the present disclosure are conducive to reducing open-circuit voltage loss and improving efficiency of the solar cell.

## Description

### TECHNICAL FIELD

Embodiments of the present disclosure relate to the field of solar cells, and in particular to a solar cell, a method for producing the solar cell and a photovoltaic module.

### BACKGROUND

Solar cells have good photoelectric conversion capabilities. Thus, solar cells are the focus of clean energy development. In order to secure the photoelectric conversion efficiency of solar cells, the research and development of solar cells are ongoing. During the production of a solar cell, recesses are formed on a surface of a substrate and respective grid line is formed in each recess. In this way, currents generated by the solar cell can be collected and transferred to the module end through a bus bar.

However, the existing solar cells have the problem of low photoelectric conversion efficiency.

### SUMMARY

Embodiments of the present disclosure provide a solar cell, a method for producing the solar cell and a photovoltaic module, which are at least conducive to reducing open-circuit voltage loss and improving photoelectric conversion efficiency of the solar cell.

Some embodiments of the present disclosure provide a solar cell, including: a substrate having a surface with a plurality of recess sets arranged at intervals along a first direction, each recess set of the plurality of recess sets including a plurality of recesses arranged at intervals along a second direction, and a distance d between adjacent recesses of the each recess set is greater than zero and less than 4L, L being a maximum dimension of a single recess of the plurality of recesses in the second direction; and a plurality of grid lines formed over the surface of the substrate. Each of the plurality of grid lines is formed in a region defined by a respective recess set and includes a first plating layer. The first plating layer includes portions formed on the surface of the substrate and extension portions extending into respective recesses of a respective recess set. Each of the extension portions is formed in a respective recess of the respective recess set and is in contact with the substrate through the recess.

In some embodiments, the maximum dimension of a recess of the plurality of recesses in the second direction ranges from 3 µm to 50 µm.

In some embodiments, the distance between adjacent recesses in the second direction is less than 200 µm.

In some embodiments, a maximum depth of a recess of the plurality of recesses in a direction perpendicular to the surface of the substrate is less than 1 µm.

In some embodiments, a shape of an orthogonal projection of a recess of the plurality of recesses on the surface of the substrate includes a circle, an ellipse or a polygon.

In some embodiments, each of the plurality of grid lines further includes a second plating layer formed on a surface of the first plating layer away from the substrate and a third plating layer formed on a surface of the second plating layer away from the substrate.

In some embodiments, a maximum thickness of the second plating layer in a direction perpendicular to the surface of the substrate is greater than a maximum thickness of the first plating layer in the direction perpendicular to the surface of the substrate and a maximum thickness of the third plating layer in the direction perpendicular to the surface of the substrate.

In some embodiments, a maximum thickness of the second plating layer in a direction perpendicular to the surface of the substrate ranges from 2 µm to 30 µm.

In some embodiments, a maximum thickness of the third plating layer in a direction perpendicular to the surface of the substrate ranges from 10 nm to 5 µm.

In some embodiments, a conductivity of the first plating layer is less than or equal to a conductivity of the second plating layer.

In some embodiments, a maximum thickness of the first plating layer in a direction perpendicular to the surface of the substrate ranges from 10 nm to 5 µm.

In some embodiments, the first plating layer includes two or more sub-plating layers sequentially formed in a direction perpendicular to the surface of the substrate.

In some embodiments, a distance between adjacent recess sets in the first direction ranges from 0.5 mm to 3 mm.

Some embodiments of the present disclosure provide a method for producing a solar cell, including: providing a substrate; forming a plurality of recess sets arranged at intervals along a first direction on a surface of the substrate, each recess set of the plurality of recess sets includes a plurality of recesses arranged at intervals in a second direction, and a distance d between adjacent recesses in the each recess set is greater than zero and less than 4L, L being a maximum dimension of a single recess of the plurality of recesses in the second direction; and forming a plurality of grid lines over the surface of the substrate. Each of the plurality of grid lines is formed in a region defined by a respective recess set and includes a first plating layer. The first plating layer includes portions formed on the surface of the substrate and extension portions extending into respective recesses of a respective recess set. Each of the extension portions is formed in a respective recess of the respective recess set and is in contact with the substrate through the recess.

In some embodiments, the plurality of recess sets are formed by laser etching, ion etching or paste etching.

In some embodiments, forming the plurality of grid lines further includes forming a second plating layer on a surface of the first plating layer away from the substrate by electroplating.

In some embodiments, forming the plurality of grid lines further includes forming a third plating layer on a surface of the second plating layer away from the substrate by electroplating or electroless plating.

Some embodiments of the present disclosure provide a photovoltaic module, including: at least one cell string including a plurality of solar cells as described above, the plurality of solar cells are electrically connected in sequence; at least one encapsulation layer configured to cover a surface of the at least one cell string; and at least one cover plate configured to cover a surface of the at least one encapsulation layer facing away from the at least one cell string.

### BRIEF DESCRIPTION OF THE DRAWINGS

One or more embodiments are exemplarily illustrated in reference to corresponding accompanying drawing(s), and these exemplary illustrations do not constitute limitations on the embodiments. Unless otherwise stated, the accompanying drawings do not constitute scale limitations.
FIG. 1 is a structural schematic diagram of the plurality of recesses of a solar cell according to some embodiments of the present disclosure.
FIG. 2 is a structural schematic diagram of the plurality of grid lines of the solar cell according to some embodiments of the present disclosure.
FIG. 3 is a structural schematic diagram of the first plating layer of the solar cell according to some embodiments of the present disclosure.
FIG. 4 is a partially enlarged structural schematic diagram of a recess according to some embodiments of the present disclosure.
FIG. 5 is another partially enlarged structural schematic diagram of a recess according to some embodiments of the present disclosure.
FIG. 6 is still another partially enlarged structural schematic diagram of a recess according to some embodiments of the present disclosure.
FIG. 7 is another structural schematic diagram of a grid line of the solar cell according to some embodiments of the present disclosure.
FIG. 8 is a flow chart of a method for producing a solar cell according to some embodiments of the present disclosure.
FIG. 9 is a structural schematic diagram of a photovoltaic module according to some embodiments of the present disclosure.

### DETAILED DESCRIPTION OF THE EMBODIMENTS

It can be known from the background art that the existing solar cells have a poor photoelectric conversion efficiency.

In the solar cell provided by embodiments of the present disclosure, a plurality of recess sets arranged at intervals in a first direction are formed on a surface of the substrate of the solar cell, each of the plurality of recess sets includes a plurality of recesses arranged at intervals in the second direction, and a distance between adjacent recesses in the second direction is greater than 0 and is less than 4 times a maximum dimension of a recess of the plurality of recesses in the second direction. In this way, the plurality of recesses of each recess set form a discontinuous pattern consisted of a plurality of concave points on the surface of the substrate, such that an etched area of each recess set and a total etched area of the plurality of recess sets on the surface of the substrate can be reduced, thereby reducing an open-circuit voltage loss and improving a photoelectric conversion efficiency of the solar cell. Moreover, the distance between adjacent recesses and the maximum dimension of a recess of the plurality of recesses in the second direction meet 0 < d < 4L. In this way, problems of an increased etching damage due to overlapping recesses resulted from an excessively small distance between adjacent recesses and of a reduced current transferring capability of the plurality of grid lines due to excessively narrow segments of a grid line in regions between adjacent recesses resulted from an excessively large distance between adjacent recesses can be avoid, thereby securing generation capability of photo-generated carriers of the solar cell and current transferring capability of the plurality of grid lines. During the production of the plurality of grid lines extending in the second direction, the first plating layer is formed in a region defined by a respective recess set on the surface of the substrate. The first plating layer includes portions formed on the surface of the substrate and extension portions each formed in a respective recess of a respective recess set, and each of the extension portions is in contact with the substrate through the recess. In this way, binding force between the plurality of grid lines and the substrate can be improved, and reduction of the photoelectric conversion efficiency of the solar cell due to one or more grid lines of the solar cell becoming out of contact with the substrate can be avoided, thereby securing the photoelectric conversion efficiency of the solar cell.

Embodiments of the present disclosure will be described in detail below with reference to the accompanying drawings. Those skilled in the art should understand that, in the embodiments of the present disclosure, many technical details are provided for the reader to better understand the present disclosure. However, even without these technical details and various modifications and variants based on the following embodiments, the technical solutions claimed in the present disclosure can be realized.

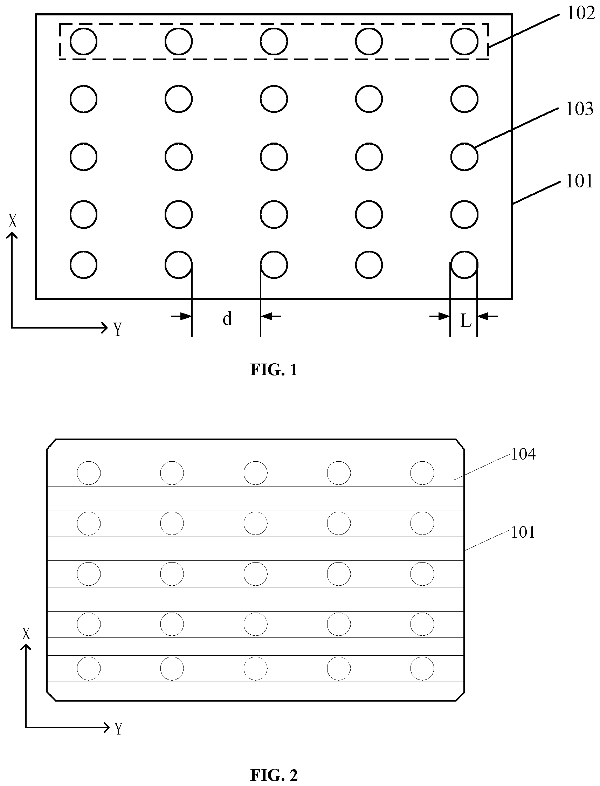

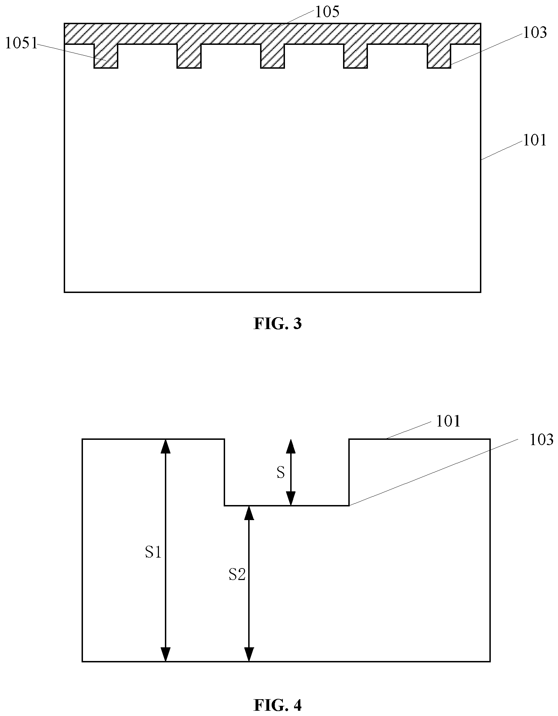

Referring to FIGS. 1 to 3, FIG. 1 is a structural schematic diagram of the plurality of recesses on the surface of the solar cell, FIG. 2 is a structural schematic diagram of the plurality of grid lines on the surface of the solar cell, and FIG. 3 is a structural schematic diagram of the first plating layer. The solar cell includes a substrate 101 and a plurality of grid lines 104. A plurality of recess sets 102 arranged at intervals in a first direction are formed on a surface of the substrate 101, and each of the plurality of grid lines 104 is formed in a region defined by a respective recess set 102 and extends in a second direction on the surface of the substrate 101. Each of the plurality of recess sets 102 includes a plurality of recesses 103 arranged at intervals in the second direction, and 0 < d < 4L, herein d refers to a distance between adjacent recesses 103 in the second direction, and L refers to a maximum dimension of a recess 103 of the plurality of recesses in the second direction. Each of the plurality of grid lines 104 includes a first plating layer 105. The first plating layer 105 includes portions formed on the surface of the substrate 101 and extension portions 1051 each formed in a respective recess 103 of a respective recess set 102, and each of the extension portions 1051 is in contact with the substrate 101 through the recess 103. Herein, direction X refers to the first direction, and direction Y refers to the second direction.

The plurality of recess sets 102 arranged at intervals in the first direction on the surface of the substrate 101 may be formed by laser etching, ion etching, paste etching or the like. Each of the plurality of recess sets 102 includes a plurality of recesses 103 arranged at intervals in the second direction, and the distance d between adjacent recesses 103 in the second direction is greater than 0 and is less than 4 times a maximum dimension L of a recess 103 of the plurality of recesses in the second direction. For example, d may be equal to 0.5L, L, 1.5L, 2L, 3L, and so on. During the formation of the plurality of recess sets 102 arranged at intervals in the first direction on the surface of the substrate 101 of the solar cell, each of the plurality of recess sets 102 is provided with a plurality of recesses 103 arranged at intervals in the second direction, and the distance d between adjacent recesses 103 in the second direction is set to be greater than 0 and is less than 4 times a maximum dimension L of a recess 103 of the plurality of recesses in the second direction. In this way, recess sets 102 including a plurality of recesses 103 arranged at intervals can be obtained, and each recess set 102 forms a discontinuous pattern consisted of a plurality of concave points, such that a total etched area on the surface of the substrate 101 can be reduced, thereby reducing an open-circuit voltage loss and improving a photoelectric conversion efficiency of the solar cell. During the production of the plurality of grid lines 104 extending in the second direction, the plurality of grid lines 104 contact with the substrate 101 through the first plating layer 105. The first plating layer 105 includes portions formed on the surface of the substrate 101 and extension portions 1051 each contact with the substrate 101 through a respective recess 103 of a respective recess set 102. Since the first plating layer 105 includes not only the portions formed on the surface of the substrate 101, but also the extension portions 1051 contacted with the substrate 101 through the recess 103, the bonding force between the plurality of grid lines 104 and the substrate 101 can be greatly enhanced, thereby ensuring stability of the plurality of grid lines 104 arranged on the substrate 101. In this way, the problem of a reduced collection capability of currents of the solar cell due to one or more grid lines 104 becoming out of contact with the substrate 101 can be avoided, thereby securing the photoelectric conversion efficiency of the solar cell.

Moreover, the distance between adjacent recesses 103 and the maximum dimension of a recess 103 of the plurality of recesses in the second direction meet 0 < d < 4L. The distance between adjacent recesses 103 is set to be greater than 0, in order to avoid the problem of an increased etching damage due to overlapping adjacent recesses 103 resulted from an excessively small distance between adjacent recesses 103, and generation capability of photo-generated carriers of the solar cell can be secured. Since each of the plurality of grid lines 104 grows, in the second direction, from the plurality of recesses 103 of a respective recess set, a largest width of an obtained grid line 104 occurs at a center of a recess 103, and the width of the obtained grid line 104 decreases as being away from the center of a recess 103. In view of this, the distance between adjacent recesses 103 is set to a value less than 4L, in order to ensure widths of segments of a grid line 104 in regions between adjacent recesses 103 to be large enough, and problem of a reduced current transferring capability of the plurality of grid lines due to excessively narrow segments of a grid line 104 in regions between adjacent recesses 103 resulted from an excessively large distance between adjacent recesses 103 can be avoid, thereby securing current transferring capability of the plurality of grid lines. Furthermore, the plurality of grid lines 104 are formed in a way that each of the plurality of grid lines 104 has no excessively narrow segment between adjacent recesses and no excessive width at each recess 103. In this way, a reduced light absorption area of the solar cell due to increased surface area occupied by the plurality of grid lines 104 on the surface of the substrate 101 can be avoided, thereby securing light absorption capability of the solar cell.

The substrate 101 is configured to receive incoming light and generate photo-generated carriers. In some embodiments, materials of the substrate 101 may be a silicon substrate, and the materials of the silicon substrate may include at least one of monocrystalline silicon, polycrystalline silicon, amorphous silicon or microcrystalline silicon. In some other embodiments, materials of the substrate 101 may include silicon carbide, organic material or multicomponent compound. The multicomponent compound may include but not limited to materials such as perovskite, gallium arsenide, cadmium telluride, copper indium selenium or the like.

In some embodiments, the first direction and the second direction may be perpendicular to each other or have an included angle of less than 90 degrees, for example, 60 degrees, 45 degrees, 30 degrees, etc., as long as the first direction and the second direction being different directions. For the convenience of description and understanding, embodiments of the present disclosure take the first direction and the second direction perpendicular to each other as examples to illustrate. In specific applications, the included angle between the first direction and the second direction may be set or adjusted according to actual needs and application scenarios, and embodiments of the present disclosure are not limited to this.

In some embodiments, the maximum dimension of a recess 103 of the plurality of recesses in the second direction ranges from 3 µm to 50 µm. The plurality of grid lines 104 contact, through the plurality of recesses 103, with the substrate 101 by means of the extension portions 1051 of the first plating layers 105. The contact resistance between a grid line 104 and the substrate 101 depends on cross-sectional areas of the plurality of recesses 103. The larger the cross-sectional areas of the plurality of recesses 103, the lower the resistance between the grid line 104 and the substrate 101 being in electrical contact through the extension portions 1051. However, excessively large cross-sectional areas of the plurality of recesses 103 lead to increased open-circuit voltage loss of the solar cell, thereby affecting the photoelectric conversion efficiency of the solar cell. When the plurality of recesses 103 have identical widths and depths, an excessively small maximum dimension of a recess 103 of the plurality of recesses in the second direction leads to an excessively high resistance between a grid line 104 and the substrate 101, thereby affecting the current collection and transferring capabilities of the grid line 104. When a recess 103 of the plurality of recesses has an excessively large maximum dimension in the second direction, the solar cell has an excessively high open-circuit voltage loss and reduced photoelectric conversion efficiency.

In view of this, the maximum dimension of the plurality of recesses 103 of each recess set 102 in the second direction is set to be within a range of 3 µm to 50 µm, in order to balance the contact resistance between the grid lines 104 and the substrate 101 being in electrical contact with each other and the open-circuit voltage loss of the solar cell. For example, the maximum dimension of a recess 103 in the second direction is set to be 4 µm, 6 µm, 10 µm, 25 µm, 45 µm or the like. By setting the maximum dimension of a recess 103 of the plurality of recesses in the second direction to be within the range of 3 µm to 50 µm, an etched area on the surface of the substrate 101 and therefore an open-circuit voltage loss of the solar cell can be reduced, thereby improving a photoelectric conversion efficiency of the solar cell. Meanwhile, in this way, the contact resistance between the extension portions 1051 of the grid lines 104 and the substrate 101 can be low as much as possible, thereby avoiding reduced current collection and transferring capabilities of the grid lines 104 due to excessive contact resistance, and avoiding a resulted reduction in efficiency of the solar cell.

In some embodiments, in order to prevent a recess 103 from having an excessive area on the surface of the substrate 101, during the formation of the recess 103, a maximum dimension of connecting lines between any two points on the edge of the recess 103 is set to be within the range of 3 µm to 50 µm. For example, when forming a recess 103 by laser etching, the distance between any two points on the edge of the laser spot is set to be within the range of 3 µm to 50 µm. Thus, the area of the recess 103 on the surface of the substrate 101 is limited to an area of a circle with a diameter of 3 µm to 50 µm. In this way, the contact resistance between the grid lines 104 and the substrate 101 and the open-circuit voltage loss of the solar cell can be reduced as much as possible, thereby securing the efficiency of the solar cell.

In some embodiments, the distance between adjacent recesses 103 in the second direction is less than 200 µm. Given that a maximum length of the substrate 101 in the second direction is fixed, a number of the plurality of recesses 103 of a recess set 102 depends on not only the maximum dimension of a recess of the plurality of recesses 103 in the second direction, but also the distance between adjacent recesses 103 in the second direction. An excessively large distance between adjacent recesses 103 in the second direction leads to an excessively small number of the plurality of recesses 103 of a recess set 102, thereby leading to a small etched area on the surface of the substrate 101, a relative high contact resistance between the grid lines 104 and the substrate 101, poor current collection and transferring capabilities of the grid lines 104, and a low photoelectric conversion efficiency of the solar cell.

In view of this, in order to balance the contact resistance between the grid lines 104 and the substrate 101 and the open-circuit voltage loss of the solar cell, during the formation of the plurality of recesses 103, not only a relationship between the maximum dimension of a recess 103 of the plurality of recesses in the second direction and the distance between adjacent recesses 103 in the second direction, but also a maximum value of the distance between adjacent recesses 103 in the second direction should be taken into account. The distance between adjacent recesses 103 in the second direction is set to be less than 200 µm, for example, the distance between adjacent recesses 103 is set to be 3 µm, 6 µm, 12 µm, 60 µm, 120 µm or the like, depending on the maximum dimension of a recess 103. In this way, an etched area on the surface of the substrate 101 can be ensured to be large enough, thereby preventing a reduced efficiency of the solar cell due to reduced current collection and transferring capabilities of the grid lines 104.

It should be understood that the distance between adjacent recesses 103 may vary or be fixed, as long as the conditions that the distance between adjacent recesses 103 in the second direction is less than 200 µm, and is greater than 0 and less than 4 times the maximum dimension of a recess 103 of the plurality of recesses in the second direction are met. Embodiments of the present disclosure do not limit the distance between adjacent recesses 103 to fixed.

In some embodiments, a shape of an orthogonal projection of a recess 103 of the plurality of recesses on the surface of the substrate 101 includes a circle, an ellipse or a polygon. The plurality of recesses 103 are configured to receive the extension portions 1051 of the first plating layer 105 of a respective grid line 104, such that the extension portions 1051 can contact with the substrate 101 through the recess 103. Thus, the shape of the orthogonal projection of a recess 103 of the plurality of recesses on the surface of the substrate 101 can be set according to the material selected for producing the first plating layer 105 and the specific application scenario for the grid lines 104.

For example, in a case that the material selected for producing the first plating layer 105 has a high resistance, a recess 103 of which the orthogonal projection on the surface of the substrate 101 has a shape of a circle or an ellipse and has a relatively large area may be formed, so as to maximize, through the extension portion 1051 in the recess 103, the contact area between the respective grid line 104 and the substrate 101 when the electrical contact occurs, and to reduce the contact resistance between the respective grid line 104 and the substrate 101. In a case that the material selected for producing the first plating layer 105 has a low resistance, a recess 103 of which the orthogonal projection on the surface of the substrate 101 has a shape of a polygon such as a triangle or a diamond and has a relatively small area may be formed, so as to minimize the etched area on the surface of the substrate 101 and to reduce the open-circuit voltage loss of the solar cell, thereby improving the photoelectric conversion efficiency of the solar cell. Thus, the orthogonal projection of a recess 103 of the plurality of recesses on the surface of the substrate 101 may be adjusted according to application scenarios and needs, to form a recess 103 with different cross-sectional areas. In this way, the contact resistance between the respective grid line 104 and the substrate 101 and the open-circuit voltage loss of the solar cell can be reduced as much as possible, thereby improving the photoelectric conversion efficiency of the solar cell.

In some embodiments, a maximum depth of a recess 103 of the plurality of recesses in a direction perpendicular to the surface of the substrate 101 is less than 1 µm. During the formation of the plurality of recesses 103, a shape of an orthogonal projection of an obtained recess 103 of the plurality of recesses on the surface of the substrate 101 may be selected according to needs. For the convenience of illustration, a recess 103 having a circular shaped orthogonal projection on the surface of the substrate 101 is taken as an example.

Referring to FIGS. 2 to 4, FIG. 4 is an enlarged structural schematic diagram of a single recess 103. In the direction perpendicular to the surface of the substrate 101 on which the recess 103 is formed, the maximum depth S of the recess 103 refers to a maximum extension length of the recess 103 towards the interior of the substrate 101, which may be calculated according to the following formula: S=S1-S2. S1 refers to a maximum thickness of the substrate 101 in the direction perpendicular to the surface of the substrate 101, and S2 refers to a maximum distance between a bottom of the recess 103 and a second surface of the substrate 101 in the direction perpendicular to the surface of the substrate 101, herein the second surface of the substrate 101 refers to a surface opposite to the surface of the substrate 101 on which the recess 103 is formed.

During the formation of the plurality of recesses 103, the open-circuit voltage loss and therefore the photoelectric conversion efficiency of the solar cell are also influenced by the maximum depth of a recess 103 of the plurality of recesses in the direction perpendicular to the surface of the substrate. An excessive depth of the recess 103, i.e. an excessive extension distance of the recess 103 towards the interior of the substrate 101 in the direction perpendicular to the surface of the substrate 101, may lead to a relatively high open-circuit voltage loss and a reduced photoelectric conversion efficiency of the solar cell. In view of this, during the formation of the plurality of recesses 103, the maximum depth of a recess 103 of the plurality of recesses in the direction perpendicular to the surface of the substrate 101 is set to be less than 1 µm, such as 0.1 µm, 0.15 µm, 0.3 µm, 0.5 µm, 0.85 µm, or the like. In this way, the influence on the open-circuit voltage loss of the solar cell resulted from the depth of the recess 103 can be reduced, thereby preventing the reduced photoelectric conversion efficiency of the solar cell due to excessively high open-circuit voltage loss. Moreover, the bonding force between the first plating layer 105 and the substrate 101 can be ensured to be high enough, thereby preventing reduced current collection and transferring capabilities and reduced efficiency of the solar cell resulted from the grid lines 104 becoming out of contact with the surface of the substrate 101.

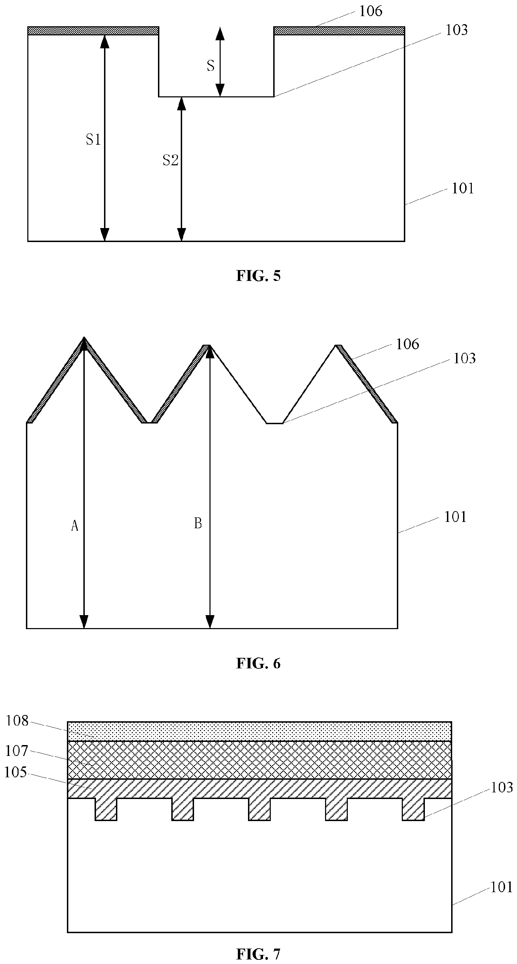

In some embodiments, referring to FIGS. 1, 5 and 6, FIG. 5 is a structural schematic diagram of a recess 103 with a dielectric film layer 106 on the plane surface of the substrate 101, and FIG. 6 is a structural schematic diagram of a recess 103 with a dielectric film layer 106 on the textured surface of the substrate 101. In the structure as shown in FIG. 5, the maximum depth of a recess 103 of the plurality of recesses in the direction perpendicular to the surface of the substrate 101 includes not only the extension distance of the recess 103 in the substrate 101, but also a maximum thickness of the dielectric film layer 106 crossed through by the recess 103, and it is the extension distance of the recess 103 in the substrate 101 which should not go beyond 1 µm. Thus, during the formation of the plurality of recesses 103, the maximum depth of a recess 103 of the plurality of recesses in the direction perpendicular to the surface of the substrate 101 may be increased appropriately depending on the maximum thickness of the dielectric film layer 106, as long as the maximum depth of the obtained recess 103 is greater than the maximum thickness of the dielectric film layer 106 and less than a sum of the maximum thickness of the dielectric film layer 106 and 1 µm. In the structure as shown in FIG. 6, the recess may be formed between two adjacent bulges on the textured surface. In a direction perpendicular to a bottom of the recess 103, the maximum depth of the recess 103 refers to a difference between a maximum distance A and a maximum distance B. Herein the maximum distance A refers to a distance between a top surface of the dielectric film layer 106 on a bulge located out of a formation region of the recess 103 and a bottom surface opposite to the textured surface of the substrate 101, and the maximum distance B refers to a distance between a top surface of the etched dielectric film layer 106 on a bulge located in a formation region of the recess 103 and a bottom surface opposite to the textured surface of the substrate 101. Thus, during the formation of the recess 103 on the substrate 101 with a textured surface, etch is performed between adjacent selected bulges on the textured surface and in a direction perpendicular to the bottom of the recess 103 and directing to the interior of the substrate 101, and the maximum distance between the top surface of the dielectric film layer 106 and the bottom surface of the substrate 101 reduce, after the etch, by not more than 1 µm.

Referring to FIGS. 1 to 7, in some embodiments, each of the plurality of grid lines 104 further includes a second plating layer 107 formed on a surface of the first plating layer 105 away from the substrate 101 and a third plating layer 108 formed on a surface of the second plating layer 107 away from the substrate 101.

During the formation of the plurality of grid lines 104, not only the bonding stability between the plurality of grid lines 104 and the substrate 101, but also the current transferring capability and working capability, under the condition that scrape or collision occurs, of the plurality of grid lines 104 in use of the solar cell should be taken into account. Thus, during the formation of the plurality of grid lines 104, each of the plurality of grid lines 104 is formed by the first plating layer 105, the second plating layer 107 formed on a surface of the first plating layer 105 away from the substrate 101 and the third plating layer 108 formed on a surface of the second plating layer 107 away from the substrate 101. The first plating layer 105 is mainly configured to fully bond with the substrate 101 through the portions formed on the surface of the substrate 101 and the extension portions 1051 each formed in a respective recess 103 and being in contact with the substrate 101, in order to improve the bonding stability between the plurality of grid lines 104 and the substrate 101. The second plating layer 107 is mainly configured to transfer, as a transferring center layer of a grid line 104, the collected current. The third plating layer 108 is mainly configured as a protective layer for the second plating layer 107 to prevent the second plating layer 107 from being damaged or broken under the condition that scrape or collision occurs, thereby securing the current collection and transferring capabilities of the plurality of grid lines 104.

Thus, during the formation of the plurality of grid lines 104, three plating layers are stacked to form a grid line 104. The first plating layer 105 is configured to improve the bonding stability between the plurality of grid lines 104 and the substrate 101, the second plating layer 107 is configured to secure the current transferring capability of the grid line 104, and the third plating layer 108 is configured to improve the adaptability of the grid line 104 in practical application, reduce the possibility of fracture of the grid line 104, improve working stability of the grid line 104, and ensure the photoelectric conversion efficiency of the solar cell.

In some embodiments, a maximum thickness of the second plating layer 107 in the direction perpendicular to the surface of the substrate 101 is greater than a maximum thickness of the first plating layer 105 in the direction perpendicular to the surface of the substrate 101 and a maximum thickness of the third plating layer 108 in the direction perpendicular to the surface of the substrate 101.

The second plating layer 107 is arranged between the first plating layer 105 being in contact with the substrate 101 and the third plating layer 108 functioning as a top layer, and the core function of the second plating layer 107 is to collect and transfer the current generated on the substrate 101. The current collection and transferring capabilities of the second plating layer 107 depend on its resistance. In a case of using the same materials and production process, the second plating layers 107 with a same length each have a resistance depending on its cross-sectional area, and the cross-sectional area depends on the maximum thickness in the direction perpendicular to the surface of the substrate 101 and on a maximum width in a direction perpendicular to the second direction of the second plating layers 107. Based on this, in a case that the maximum width in the direction perpendicular to the second direction of the second plating layers 107 is fixed, the resistance of a second plating layer 107 is negatively related to its maximum thickness in the direction perpendicular to the surface of the substrate 101.

Thus, given that the overall thickness of a grid line 104 is fixed, in the direction perpendicular to the surface of the substrate 101, the maximum thickness of the second plating layer 107 is increased as much as possible, such that the maximum thickness of the second plating layer 107 is greater than the maximum thicknesses of the first plating layer 105 and the third plating layer 108. In this way, overall resistance of the grid line 104 can be reduced, and the current collection and transferring capabilities of the grid line 104 can be improved, thereby securing the photoelectric conversion efficiency of the solar cell.

In some embodiments, a maximum thickness of the second plating layer 107 in the direction perpendicular to the surface of the substrate 101 ranges from 2 µm to 30 µm. The core function of the second plating layer 107, as a core layer of a grid line 104, is to collect and transfer the current. The greater the cross-sectional area of the second plating layer 107, the smaller its resistance, and the stronger the current collection and transferring capabilities. Considering the balance between an overall thickness of a grid line 104 and current collection and transferring capabilities, when the maximum thickness of the second plating layer 107 in the direction perpendicular to the surface of the substrate 101 is excessively small, its small cross-sectional area leads to an excessive resistance, which prevents efficient current collection and transferring. When the maximum thickness of the second plating layer 107 is excessively large, the grid line 104 has an excessive overall thickness, which leads to increased production cost of the grid line 104 and an excessive weight of the solar cell.

Thus, during the formation of the second plating layer 107, the maximum thickness of the second plating layer 107 in the direction perpendicular to the surface of the substrate 101 is set to be within the range of 2 µm to 30 µm, such as 3 µm, 5 µm, 8 µm, 15 µm, 25 µm, or the like. The second plating layer 107 is provided with a cross-sectional area large enough, in order to prevent an excessive resistance of the second plating layer 107, thereby securing the current collection and transferring capabilities of the grid line 104. Meanwhile, the grid line 104 is provided with an appropriate overall thickness, thereby reducing the production cost of the grid line 104 and the weight of the solar cell.

It should be understood that during the formation of the second plating layer 107, in consideration of the difference between the performance of the front surface and that of the rear surface of the solar cell, when forming a grid line 104 on the front surface of the solar cell, the maximum thickness of the second plating layer 107 in the direction perpendicular to the surface of the substrate 101 may range from 3 µm to 15 µm, such as 4 µm, 6 µm, 9 µm, 13 µm, or the like. When forming a grid line 104 on the rear surface of the solar cell, the maximum thickness of the second plating layer 107 in the direction perpendicular to the surface of the substrate 101 may range from 7 µm to 20 µm, such as 8 µm, 10 µm, 13 µm, 16 µm, or the like. Embodiments of the present disclosure do not limit the maximum thickness of the second plating layer 107 in the direction perpendicular to the surface of the substrate 101 to a specific value.

In some embodiments, a maximum thickness of the third plating layer 108 in the direction perpendicular to the surface of the substrate 101 ranges from 10 nm to 5 µm. The core function of the third plating layer 108 is to function as a protective layer for the second plating layer 107, so as to prevent the second plating layer 107 from being damaged or even broken under the condition that scrape or collision occurs on the grid line 104. Considering the balance between the overall thickness of the grid line 104 and protection ability of the third plating layer 108 to the second plating layer 107, when the maximum thickness of the third plating layer 108 in the direction perpendicular to the surface of the substrate 101 is excessively small, its protection ability is limited, since the protection ability is positively related to the maximum thickness of the third plating layer 108, which cannot prevent the second plating layer 107 from being damaged under the condition that scrape or collision occurs on the grid line 104. When the maximum thickness of the third plating layer 108 is excessively large, the grid line 104 has an excessive overall thickness, which leads to increased production cost of the grid line 104 and an excessive weight of the solar cell.

In view of this, when other parameters are kept unchanged, the maximum thickness of the third plating layer 108 in the direction perpendicular to the surface of the substrate 101 is set to be within the range of 10 nm to 5 µm, such as 50 nm, 150 nm, 500 nm, 1 µm, 2 µm, 4 µm, or the like. In this way, the protection ability of the third plating layer 108 to the second plating layer 107 can be secured, the grid line 104 can have an appropriate overall thickness, and the production cost of the grid line 104 and the weight of the solar cell can be reduced.

In some embodiments, a maximum thickness of the first plating layer 105 in the direction perpendicular to the surface of the substrate 101 ranges from 10 nm to 5 µm. The core function of the first plating layer 105 is to increase the bonding force between the grid line 104 and the substrate 101, thereby preventing the grid line 104 from becoming out of contact with the substrate or the occurrence of virtual open circuit when in use of the solar cell. Considering the balance between the overall thickness of the grid line 104 and the improvement of the bonding force by the first plating layer 105, when the maximum thickness of the first plating layer 105 in the direction perpendicular to the surface of the substrate 101 is excessively small, the first plating layer 105 has a relatively low limit of force, which cannot effectively prevent the grid line 104 from becoming out of contact with the substrate or the occurrence of virtual open circuit when in use of the solar cell. When the maximum thickness of the first plating layer 105 is excessively large, the grid line 104 has an excessive overall thickness, which leads to increased production cost of the grid line 104 and an excessive weight of the solar cell.

In view of this, when other parameters are kept unchanged, the maximum thickness of the first plating layer 105 in the direction perpendicular to the surface of the substrate 101 is set to be within the range of 10 nm to 5 µm, such as 100 nm, 500 nm, 1 µm, 2 µm, 4 µm, or the like. In this way, the improvement of the bonding force, by the first plating layer 105, between the grid line 104 and the substrate 101 can be secured, thereby preventing the grid line 104 from becoming out of contact with the substrate. Meanwhile, the grid line 104 can have an appropriate overall thickness, and the production cost of the grid line 104 and the weight of the solar cell can be reduced.

In some embodiments, the first plating layer 105 includes two or more sub-plating layers sequentially formed in the direction perpendicular to the surface of the substrate. The core function of the first plating layer 105 is to increase the bonding force between the grid line 104 and the substrate 101. During the formation of the first plating layer 105, the desired first plating layer 105 may be divided into two or more sub-plating layers in the direction perpendicular to the surface of the substrate 101, and these two or more sub-plating layers may be formed one by one to form the first plating layer 105. By forming two or more sub-plating layers one by one to form the first plating layer 105, the first plating layer 105 can be formed by a plurality of stacked sub-plating layers which have more uniform structure. In this way, tightness of the structure of the first plating layer 105 can be further improved, and the limit of force of the first plating layer 105 can be increased, thereby increasing the bonding force between the grid line 104 and the substrate, and effectively preventing the grid line 104 from becoming out of contact with the substrate or the occurrence of virtual open circuit.

In some embodiments, a conductivity of the first plating layer 105 is less than or equal to a conductivity of the second plating layer 107. The core function of the first plating layer 105 is to increase the bonding force between the grid line 104 and the substrate 101, and the core function of the second plating layer 107 is to secure the current collection and transferring capabilities of the grid line 104. Thus, during the formation of the first plating layer 105, give priority to the influence of selected materials on the bonding force between the first plating layer 105 and the substrate 101, and materials with relatively high bonding force are selected to form the first plating layer 105. During the formation of the second plating layer 107, give priority to conductivity of selected materials, and materials with relatively high conductivity are selected to form the second plating layer 107. Thus, a first plating layer 105 with relatively low conductivity and high bonding force with the substrate 101 and a second plating layer 107 with relatively high conductivity can be obtained. In this way, the bonding stability between the grid line 104 and the substrate 101 as well as the current collection and transferring capabilities of the grid line 104 can be secured, thereby securing the photoelectric conversion efficiency of the solar cell.

In some embodiments, a distance between adjacent recess sets 102 in the first direction ranges from 0.5 mm to 3 mm. Each of the plurality of grid lines 104 is formed in a region defined by a respective recess set 102. Thus, density of the plurality of grid lines 104 on the surface of the solar cell depends on the distance between adjacent recess sets 102. Since the plurality of grid lines 104 are configured to collect and transfer the currents generated by the solar cell, the smaller the distance between adjacent recess sets 102 in the first direction, i.e. the higher the density of the plurality of grid lines 104, the stronger the current collection and transferring capabilities of the solar cell. However, the higher the density of adj acent recess sets 102, the larger the etched area on the surface of the solar cell, the higher the open-circuit voltage loss, which leads to a reduced current generation capability of the solar cell.

In view of this, during the formation of the adjacent recess sets 102, not only the current collection and transferring capabilities of the grid lines 104, but also the open-circuit voltage loss and current generation capability of the solar cell should be taken into account. The distance between adjacent recess sets 102 is set to be within the range of 0.5 mm to 3 mm, such as 0.6 mm, 1 mm, 1.5 mm, 2 mm, 2.8 mm, or the like. In this way, the current collection and transferring capabilities of the solar cell can be improved by an appropriate density of the plurality of grid lines 104 on the surface of the solar cell, and the solar cell can have an appropriate open-circuit voltage loss, thereby preventing from influencing the current generation capability and photoelectric conversion efficiency of the solar cell.

In the solar cell as illustrated above, a plurality of recess sets 102 arranged at intervals in the first direction are formed on the surface of the substrate 101, each of the plurality of recess sets 102 includes a plurality of recesses 103 arranged at intervals in the second direction, and the distance between adjacent recesses 103 in the second direction is greater than 0 and is less than 4 times the maximum dimension of a recess 103 of the plurality of recesses in the second direction. In this way, the plurality of recesses of each recess set 102 form a discontinuous pattern consisted of a plurality of concave points, such that an etched area on the surface of the substrate can be reduced, thereby reducing an open-circuit voltage loss and improving a photoelectric conversion efficiency of the solar cell. During the production of the plurality of grid lines, the first plating layer 105 is formed in a region defined by a respective recess set 102 on the surface of the substrate 101. The first plating layer 105 includes portions formed on the surface of the substrate 101 and extension portions 1051 extending into respective recesses 103 of a respective recess set 102, each of the extension portions 1051 is formed in a respective recess 103 of the respective recess set 102 and is in contact with the substrate 101 through the recess 103. In this way, binding force between the plurality of grid lines 104 and the substrate 101 can be improved, and reduction of the photoelectric conversion efficiency of the solar cell due to one or more grid lines 104 becoming out of contact with the substrate 101 can be avoided, thereby securing the photoelectric conversion efficiency of the solar cell.

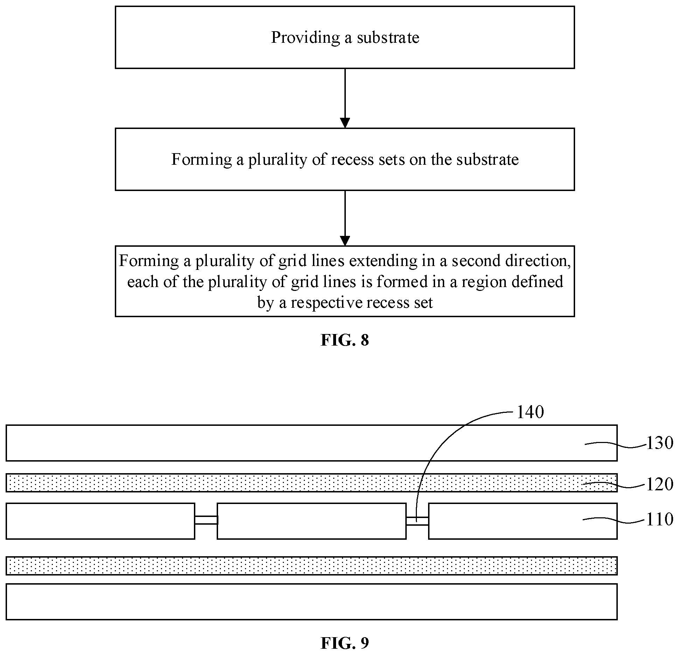

Embodiments of the present disclosure further provide a method for producing the solar cell as illustrated above. The process of the method can be seen in FIG. 8, including operations as follows.

Providing a substrate 101.

Referring to FIGS. 1 and 3, forming a plurality of recess sets 102 on the substrate 101.

During the operation of forming the plurality of recess sets 102 on the surface of the substrate 101, the plurality of recess sets 102 are arranged at intervals in a first direction on a surface of the substrate 101, each of the plurality of recess sets 102 includes a plurality of recesses 103 arranged at intervals in a second direction, and 0 < d < 4L, herein d refers to a distance between adjacent recesses 103 in the second direction, and L refers to a maximum dimension of a recess 103 of the plurality of recesses in the second direction.

In some embodiments, the operation of forming the plurality of recess sets 102 includes laser etching, ion etching or paste etching. A suitable process can be selected among the plurality of etching processes according to scenarios and needs, in order to improve the adaptability of the solution.

Referring to FIGS. 2 and 3, forming a plurality of grid lines 104, each of the plurality of grid lines 104 is formed in a region defined by a respective recess set 102 and extends in the second direction.

During the operation of forming the plurality of grid lines 104, a first plating layer 105 is formed in the region defined by a respective recess set 102. The first plating layer 105 includes portions formed on the surface of the substrate 101 and extension portions 1051 extending into respective recesses 103 of a respective recess set 102, each of the extension portions 1051 is formed in a respective recess 103 of the respective recess set 102 and is in contact with the substrate 101 through the recess 103. A respective grid line 104 is formed based on the first plating layer 105.

In some embodiments, the first plating layer 105 is formed by a process of electroplating, electroless plating or physical vapor deposition. A suitable process can be selected among the plurality of plating layer production processes according to scenarios and needs, in order to improve the adaptability and practicability of the solution.

In some embodiments, referring to FIGS. 2 and 7, the operation of forming the plurality of grid lines 104 further includes forming a second plating layer 107 on a surface of the first plating layer 105 away from the substrate 101 by electroplating.

In some embodiments, the operation of forming the plurality of grid lines 104 further includes forming a third plating layer 108 on a surface of the second plating layer 107 away from the substrate 101 by electroplating or electroless plating.

In some embodiments, the materials of the first plating layer 105 include one or more of nickel, copper, titanium, aluminum, gold, titanium, zinc, cobalt, palladium, indium, chromium and tungsten. The second plating layer 107 may include copper or the like, and the third plating layer 108 may include tin, silver, or the like.

Embodiments of the present disclosure further provide a photovoltaic module, referring to FIG. 9, the photovoltaic module includes: at least one cell string including a plurality of solar cells 110 as illustrated hereinabove, the plurality of solar cells 101 are electrically connected in sequence; at least one encapsulation layer 120 configured to cover a surface of the at least one cell string; and at least one cover plate 130 configured to cover a surface of the at least one encapsulation layer 120 facing away from the at least one cell string. The solar cells 110 are electrically connected in a form of a whole piece or multiple pieces to form a plurality of cell strings, and the plurality of cell strings are electrically connected in series and/or parallel.

In some embodiments, the plurality of cell strings may be electrically connected through conductive bars 140. The encapsulation layers 120 cover the front and rear surfaces of the solar cells 110. In some embodiments, the encapsulation layers 120 may be an organic encapsulation adhesive film such as an ethylene vinyl acetate copolymer (EVA) adhesive film, a polyethylene octene copolymer (POE) adhesive film, or a polyethylene terephthalate (PET) adhesive film. In some embodiments, the cover plate 130 may be a glass cover plate, a plastic cover plate or the like with a light transmission function. In some embodiments, a surface of the cover plate 130 facing to the encapsulation layer 120 may be a textured surface, thereby increasing the utilization of incident light.

Although the present disclosure is disclosed above with exemplary embodiments, they are not used to limit the claims. Any person skilled in the art can make some possible changes and modifications without departing from the concept of the present disclosure. The scope of protection of the present disclosure shall be subject to the scope defined by the claims.

Those having ordinary skill in the art shall understand that the above embodiments are exemplary implementations for realizing the present disclosure. In practice, any person skilled in the art to which the embodiments of the present disclosure belong may make any modifications and changes in forms and details without departing from the scope of the present disclosure. Therefore, the patent protection scope of the present disclosure shall still be subject to the scope limited by the appended claims.

## Claims

1. A solar cell, **characterized by** comprising:
a substrate having a surface with a plurality of recess sets arranged at intervals along a first direction, each recess set of the plurality of recess sets including a plurality of recesses arranged at intervals along a second direction, wherein a distance d between adjacent recesses of the each recess set is greater than zero and less than 4L, L being a maximum dimension of a single recess of the plurality of recesses in the second direction; and
a plurality of grid lines formed over the surface of the substrate;
wherein each of the plurality of grid lines is formed in a region defined by a respective recess set and comprises a first plating layer, the first plating layer comprises portions formed on the surface of the substrate and extension portions extending into respective recesses of a respective recess set, each of the extension portions is formed in a respective recess of the respective recess set and is in contact with the substrate through the recess.

2. The solar cell according to claim 1, wherein the maximum dimension of a recess of the plurality of recesses in the second direction ranges from 3 µm to 50 µm.

3. The solar cell according to claim 1, wherein the distance between adjacent recesses in the second direction is less than 200 µm.

4. The solar cell according to claim 1, wherein a maximum depth of a recess of the plurality of recesses in a direction perpendicular to the surface of the substrate is less than 1 µm.

5. The solar cell according to claim 1, wherein a shape of an orthogonal projection of a recess of the plurality of recesses on the surface of the substrate comprises a circle, an ellipse or a polygon.

6. The solar cell according to claim 1, wherein each of the plurality of grid lines further comprises a second plating layer formed on a surface of the first plating layer away from the substrate and a third plating layer formed on a surface of the second plating layer away from the substrate.

7. The solar cell according to claim 6, wherein a maximum thickness of the second plating layer in a direction perpendicular to the surface of the substrate is greater than a maximum thickness of the first plating layer in the direction perpendicular to the surface of the substrate and a maximum thickness of the third plating layer in the direction perpendicular to the surface of the substrate.

8. The solar cell according to claim 6, wherein a maximum thickness of the second plating layer in a direction perpendicular to the surface of the substrate ranges from 2 µm to 30 µm.

9. The solar cell according to claim 6, wherein a maximum thickness of the third plating layer in a direction perpendicular to the surface of the substrate ranges from 10 nm to 5 µm.

10. The solar cell according to claim 6, wherein a conductivity of the first plating layer is less than or equal to a conductivity of the second plating layer.

11. The solar cell according to claim 1, wherein a maximum thickness of the first plating layer in a direction perpendicular to the surface of the substrate ranges from 10 nm to 5 µm.

12. The solar cell according to claim 1, wherein the first plating layer comprises two or more sub-plating layers sequentially formed in a direction perpendicular to the surface of the substrate.

13. The solar cell according to claim 1, wherein a distance between adjacent recess sets in the first direction ranges from 0.5 mm to 3 mm.

14. A method for producing a solar cell, **characterized by** comprising:
providing a substrate;
forming a plurality of recess sets arranged at intervals along a first direction on a surface of the substrate, wherein each recess set of the plurality of recess sets includes a plurality of recesses arranged at intervals in a second direction, and a distance d between adjacent recesses in the each recess set is greater than zero and less than 4L, L being a maximum dimension of a single recess of the plurality of recesses in the second direction; and
forming a plurality of grid lines over the surface of the substrate, wherein each of the plurality of grid lines is formed in a region defined by a respective recess set and comprises a first plating layer, the first plating layer comprises portions formed on the surface of the substrate and extension portions extending into respective recesses of a respective recess set, each of the extension portions is formed in a respective recess of the respective recess set and is in contact with the substrate through the recess.

15. A photovoltaic module, **characterized by** comprising:
at least one cell string including a plurality of solar cells according to any one of claims 1 to 13, wherein the plurality of solar cells are electrically connected in sequence;
at least one encapsulation layer configured to cover a surface of the at least one cell string; and
at least one cover plate configured to cover a surface of the at least one encapsulation layer facing away from the at least one cell string.
